# EUROPEAN PATENT APPLICATION

(11) **EP 4 815 058 A1**
(43) Date of publication of application: **30.09.2026**
(21) Application number: 24918186.8
(22) Date of filing: 08.11.2024
(51) Int. Cl.: H01M 4/505, H01M 4/525, H01M 10/0525, C30B 29/52

(54) **LITHIUM-NICKEL-COBALT-MANGANESE POSITIVE ELECTRODE MATERIAL AND PREPARATION METHOD THEREFOR, POSITIVE ELECTRODE AND BATTERY**

(30) Priority: 17.01.2024 CN 202410069386
(71) Applicant: XTC New Energy Materials (Xiamen) Co., Ltd., Xiamen, Fujian 361026 (CN)
(72) Inventor: ZENG, Leiying, Xiamen, Fujian 361000 (CN); CHEN, Mengyao, Xiamen, Fujian 361000 (CN); WANG, Jingren, Xiamen, Fujian 361000 (CN); WEI, Xiaonan, Xiamen, Fujian 361000 (CN); WEI, Guozhen, Xiamen, Fujian 361000 (CN)
(74) Representative: Murgitroyd & Company
(86) International application number: PCT/CN2024/130900
(87) International publication number: WO 2025/152577

(57) **Abstract**

A lithium nickel cobalt manganese cathode material and a preparation method therefor, as well as a cathode and a battery, are provided, belonging to the technical field of battery materials. The lithium nickel cobalt manganese cathode material includes a single-crystal lithium nickel cobalt manganese and a modification layer located at an internal grain boundary of the single-crystal lithium nickel cobalt manganese, where the modification layer is generated by a reaction of Li, A, B, and oxygen, element A is at least one selected from the group of elements W, Mo, and Re, and element B is at least one selected from the group of Ba and Ca. The preparation method for the lithium nickel cobalt manganese cathode material includes uniformly mixing a nickel-cobalt-manganese precursor, a lithium source, an additive A, and an additive B, followed by sintering. The lithium nickel cobalt manganese cathode material can be prepared by the preparation method. The preparation method is simple, and the prepared cathode material has better electrochemical performance.

## Description

### CROSS-REFERENCE TO RELATED APPLICATION

This application claims priority to Chinese Patent Application No. 2024100693865, filed with the China National Intellectual Property Administration on January 17, 2024 and entitled "Lithium nickel cobalt manganese cathode material and preparation method therefor, as well as cathode and battery", which is incorporated herein by reference in its entirety.

### TECHNICAL FIELD

The present disclosure relates to the technical field of battery materials, and specifically, to a lithium nickel cobalt manganese cathode material and a preparation method therefor, as well as a cathode and a battery.

### BACKGROUND

As lithium-ion batteries are widely used in new energy vehicles, safety problems are the main challenge for lithium-ion batteries. A polycrystalline cathode suffers from severe microcracks during long-term cycling, leading to rapid capacity decay, while a single-crystal cathode material can effectively suppress the formation of microcracks, alleviate side reactions between a cathode surface and an electrolyte, and prolong cycle life. Therefore, a single-crystal ternary material is of great research significance for improving the cycle performance and safety performance of the lithium-ion battery. However, the single-crystal cathode material also has some problems during charge and discharge, for example, during high-voltage charge and discharge, a new interface exposed by rupture of internal grain boundaries may cause side reactions with the electrolyte, exerting an influence on the cycle performance and safety.

Currently known methods for preparing a single-crystal multi-element cathode material include, for example, mixing a multi-element cathode material matrix with a grain boundary stabilizer, followed by sintering to obtain the single-crystal multi-element cathode material. Although this solution does not emphasize the preparation method for the multi-element cathode material matrix, in practice, two-step sintering is required from the precursor to a finished product, making the preparation method not concise enough in operation.

### SUMMARY

An objective of the present disclosure is to provide a lithium nickel cobalt manganese cathode material and a preparation method therefor, as well as a cathode and a battery.

The present disclosure is implemented as follows:
According to a first aspect, the present disclosure provides a lithium nickel cobalt manganese cathode material, which includes a single-crystal lithium nickel cobalt manganese and a modification layer located at an internal grain boundary of the single-crystal lithium nickel cobalt manganese, where the modification layer is generated by the reaction of Li, A, B and oxygen, element A is at least one selected from the group of elements W, Mo, and Re, and element B is at least one selected from the group of Ba and Ca.

In an optional implementation, a ratio of the element A to the lithium nickel cobalt manganese cathode material ranges from 1500 ppm to 6000 ppm, and a ratio of the element B to the lithium nickel cobalt manganese cathode material ranges from 500 ppm to 6000 ppm.

In an optional implementation, a chemical formula of the single-crystal lithium nickel cobalt manganese is LiNiₓCo_{y}Mn_{1-x-y}O₂, where 0<x<1, 0<y<1, and 0<x+y<1.

According to a second aspect, the present disclosure provides a preparation method for a lithium nickel cobalt manganese cathode material, including:
uniformly mixing a nickel-cobalt-manganese precursor, a lithium source, an additive A, and an additive B, followed by sintering, where
the additive A is a single substance of element A or a compound of the element A, the element A is at least one selected from the group of elements W, Mo, and Re; and the additive B is a single substance of element B or a compound of the element B, and the element B is at least one selected from the group of Ba and Ca;
the additive A has a BET ranging from 5 m²/g to 10 m²/g, the additive B has a BET ranging from 5 m²/g to 10 m²/g, and the BET of the additive A is less than or equal to that of the additive B;
the additive A is added such that a ratio of the element A to a generated target lithium nickel cobalt manganese cathode material is less than or equal to 6000 ppm, and the additive B is added such that a ratio of the element B to the generated target lithium nickel cobalt manganese cathode material is less than or equal to 6000 ppm.

In an optional implementation, the additive A is added such that the ratio of the element A to the generated target lithium nickel cobalt manganese cathode material ranges from 1500 ppm to 6000 ppm, and the additive B is added such that the ratio of the element B to the generated target lithium nickel cobalt manganese cathode material ranges from 500 ppm to 6000 ppm.

In an optional implementation, the lithium source is at least one selected from the group of lithium hydroxide and lithium carbonate;
optionally, the lithium source involved in the sintering is added such that a molar ratio of a lithium element to the metal elements in the nickel-cobalt-manganese precursor is (1 to 1.07):1; and
optionally, a chemical formula of the nickel-cobalt-manganese precursor is NiₓCo_{y}Mn_{1-x-y}(OH)₂ or NiₓCo_{y}Mn_{1-x-y}CO₃, where, 0<x<1, 0<y<1, and 0<x+y<1.

In an optional implementation, the sintering includes a high-temperature sintering stage;
when 0<x≤0.4 and 0<x+y<1 in NiₓCo_{y}Mn_{1-x-y}(OH)₂, high-temperature sintering is carried out under the following conditions: a sintering atmosphere is an oxygen atmosphere or an oxygen-containing mixed atmosphere, an oxygen volume fraction ranges from 20% to 100%, a temperature ranges from 900°C to 950°C, and sintering time ranges from 7.5 h to 8.5 h;
when 0.4<x≤0.6 and 0.4<x+y<1 in NiₓCo_{y}Mn_{1-x-y}(OH)₂, high-temperature sintering is carried out under the following conditions: a sintering atmosphere is an oxygen atmosphere or an oxygen-containing mixed atmosphere, an oxygen volume fraction ranges from 30% to 100%, a temperature ranges from 880°C to 930°C, and sintering time ranges from 9.5 h to 10.5 h;
when 0.6<x≤0.7 and 0.6<x+y<1 in NiₓCo_{y}Mn_{1-x-y}(OH)₂, high-temperature sintering is carried out under the following conditions: a sintering atmosphere is an oxygen atmosphere or an oxygen-containing mixed atmosphere, an oxygen volume fraction ranges from 60% to 100%, a temperature ranges from 870°C to 920°C, and sintering time ranges from 9.5 h to 10.5 h; and
when 0.7<x<1 and 0.7<x+y<1 in NiₓCo_{y}Mn_{1-x-y}(OH)₂, high-temperature sintering is carried out under the following conditions: a sintering atmosphere is an oxygen atmosphere or an oxygen-containing mixed atmosphere, an oxygen volume fraction ranges from 70% to 100%, a temperature ranges from 830°C to 900°C, and sintering time ranges from 11.5 h to 12.5 h;
optionally, the sintering further includes a low-temperature sintering stage, and the low-temperature sintering is carried out under the following conditions: adding the low-temperature sintering step before the high-temperature sintering stage, with a low sintering temperature of 400°C to 500°C, and sintering time of 4 h to 6 h.

In an optional implementation, a primary cathode material product is obtained after sintering, and after obtaining the primary cathode material product, the method further includes:
pulverizing the primary cathode material product from D50 of 5 µm to 10 µm into D50 of 2 µm to 10 µm.

According to a third aspect, the present disclosure provides a cathode, which is prepared from the cathode material according to any one of the foregoing implementations or the cathode material prepared by using the preparation method according to any one of the foregoing implementations.

According to a fourth aspect, the present disclosure provides a battery, including the cathode according to the foregoing implementation.

The present disclosure has the following beneficial effects:

According to a lithium nickel cobalt manganese cathode material provided by an embodiment of the present disclosure, a modification layer at an internal grain boundary may suppress a side reaction between a new interface exposed by rupture of the internal grain boundary and an electrolyte during material preparation or high-voltage charge and discharge, and the modification layer can play a role of a fast-ionic conductor while protecting the internal grain boundary, thereby improving the capacity, rate, cycle and storage performance at a higher voltage. Therefore, the lithium nickel cobalt manganese cathode material provided by the embodiment of the present disclosure has excellent electrochemical performance.

According to a preparation method for a lithium nickel cobalt manganese cathode material provided by the embodiment of the present disclosure, additives A and B with appropriate BET and addition amount are selected for preparation, element B can first react with a lithium compound during a low-temperature sintering stage to form a Li-B-O compound, which then reacts with element A to form a Li-B-A-O compound modification layer. When grains begin to coalesce and grow during a high-temperature sintering stage, the Li-B-A-O compound modification layer is merely enriched at the internal grain boundary and does not penetrate into the crystal interior. This reaction proceeds spontaneously, thereby obtaining a cathode material with the modification layer at the internal grain boundary. The cathode material exhibits excellent electrochemical performance. In addition, the preparation method provided by the present disclosure is simple, and a target cathode material can be obtained with solely one-time sintering.

### BRIEF DESCRIPTION OF THE DRAWINGS

To describe technical solutions in embodiments of the present disclosure more clearly, the following briefly introduces the accompanying drawings required for describing the embodiments. It should be understood that the accompanying drawings show merely some embodiments of the present disclosure, and thus should not be construed as a limitation on the scope. A person of ordinary skill in the art may still derive other drawings from these accompanying drawings without creative efforts.
FIG. 1 is a flowchart of a preparation method according to an embodiment of the present disclosure;
FIG. 2 is a cross-sectional diagram of cathode material particles prepared according to Embodiment 3 of the present disclosure under a scanning electron microscope;
FIG. 3 is an SEM-EDS (Scanning Electron Microscopy and Energy Dispersive X-ray Spectroscopy) diagram of a cathode material prepared according to Embodiment 3 of the present disclosure;
FIG. 4 is a high-temperature cycle curve diagram of a coin cell prepared according to an embodiment and a comparative example of the present disclosure.

### DETAILED DESCRIPTION OF THE EMBODIMENTS

To make the objective, technical solutions, and advantages of embodiments of the present disclosure more clearly, the technical solutions of the embodiments of the present disclosure are clearly and completely described in detail below. For specific conditions not specified in the embodiments, conventional conditions or the conditions suggested by the manufacturer shall be followed. All reagents and instruments used without specifying the manufacturer are standard laboratory products that are commercially available.

A lithium nickel cobalt manganese cathode material and a preparation method therefor, as well as a cathode and a battery, provided by the embodiment of the present disclosure, are described in detail below.

A lithium nickel cobalt manganese cathode material provided by an embodiment of the present disclosure includes a single-crystal lithium nickel cobalt manganese and a modification layer located at an internal grain boundary of the single-crystal lithium nickel cobalt manganese, where the modification layer is generated by a reaction of Li, A, B, and oxygen, element A is at least one selected from the group of elements W, Mo, and Re, and element B is at least one selected from the group of Ba and Ca.

According to a lithium nickel cobalt manganese cathode material provided by an embodiment of the present disclosure, a modification layer at an internal grain boundary may suppress a side reaction between a new interface exposed by rupture of the internal grain boundary and an electrolyte during material preparation or high-voltage charge and discharge, and the modification layer can play a role of a fast-ionic conductor while protecting the internal grain boundary, thereby improving the capacity, rate, cycle and storage performance at a higher voltage. Therefore, the lithium nickel cobalt manganese cathode material provided by the embodiment of the present disclosure has excellent electrochemical performance.

Optionally, to ensure that the lithium nickel cobalt manganese cathode material provided by the embodiment of the present disclosure has better electrochemical performance, a ratio of the element A to the lithium nickel cobalt manganese cathode material ranges from 1500 ppm to 6000 ppm, and a ratio of the element B to the lithium nickel cobalt manganese cathode material ranges from 500 ppm to 6000 ppm.

Optionally, a chemical formula of the single-crystal lithium nickel cobalt manganese is LiNiₓCo_{y}Mn_{1-x-y}O₂, where, 0<x<1, 0<y<1, and 0<x+y<1.

A preparation method for the cathode material provided by an embodiment of the present disclosure includes the following steps.

A nickel-cobalt-manganese precursor, a lithium source, an additive A, and an additive B are uniformly mixed and then sintered.

The additive A is a single substance of element A or a compound of the element A, the element A is at least one selected from the group of elements W, Mo, and Re; and the additive B is a single substance of element B or a compound of the element B, and the element B is at least one selected from the group of Ba and Ca.

The additive A has a BET ranging from 5 m²/g to 10 m²/g, the additive B has a BET ranging from 5 m²/g to 10 m²/g, and the BET of the additive A is less than or equal to that of the additive B.

The additive A is added such that a ratio of the element A to a generated target lithium nickel cobalt manganese cathode material is less than or equal to 6000 ppm, and the additive B is added such that a ratio of the element A to the generated target lithium nickel cobalt manganese cathode material is less than or equal to 6000 ppm.

According to a preparation method provided by the embodiment of the present disclosure, the element B can first react with a lithium compound during a low-temperature sintering stage to form a Li-B-O compound, which then reacts with element A to form a Li-B-A-O compound modification layer, so that the Li-B-A-O compound modification layer is merely enriched at the internal grain boundary and does not penetrate into the crystal interior. This reaction proceeds spontaneously. During preparation, it is required that the specific surface area of each of the additive A and the additive B ranges from 5 m²/g to 10 m²/g, and the specific surface area of the additive A is not greater than that of the additive B. If the specific surface area of each of the additive A and the additive B (collectively referred to as additives hereinafter) is less than 5 m²/g, it is unfavorable for the reaction of the elements A and B with lithium. If the specific surface area of the additive is greater than 10 m²/g, the additive may react with elements other than lithium. If the specific surface area of the additive A is greater than that of the additive B, the element A may react with the lithium compound in advance. Conditions beyond the foregoing three requirement ranges cannot achieve the formation of a Li-containing compound coating layer merely at the internal grain boundary. In addition, this solution also requires that the additive A is added such that a ratio of the element A to a generated target lithium nickel cobalt manganese cathode material is less than or equal to 6000 ppm, and the additive B is added such that a ratio of the element B to the generated target lithium nickel cobalt manganese cathode material is less than or equal to 6000 ppm. If the content of the additive is higher than a requirement range, a reaction product of the additive and the lithium compound may enter the interior of the crystal to destroy the internal structure of the crystal.

Therefore, the lithium nickel cobalt manganese cathode material with outstanding electrochemical performance can be prepared by using the preparation method provided by the embodiment of the present disclosure.

Optionally, the additive A is added such that the ratio of the element A to the generated target lithium nickel cobalt manganese cathode material ranges from 1500 ppm to 6000 ppm (such as 1500 ppm, 2000 ppm, 3000 ppm, 4000 ppm, 5000 ppm, or 6000 ppm), and the additive B is added such that the ratio of the element B to the generated target lithium nickel cobalt manganese cathode material ranges from 500 ppm to 6000 ppm (such as 500 ppm, 1000 ppm, 1500 ppm, 2000 ppm, 3000 ppm, 4000 ppm, 5000 ppm, or 6000 ppm).

An addition amount of the additive A element ranges from 1500 ppm to 6000 ppm, and an addition amount of the additive B element ranges from 500 ppm to 6000 ppm. If the addition amount of the additive A and the additive B is lower than the foregoing optimal range, the reaction products of A and B with the lithium cannot spontaneously form a sufficiently thick coating layer at the internal grain boundary, and thus cannot effectively suppress the side reaction between the internal grain boundary after rupture with the electrolyte.

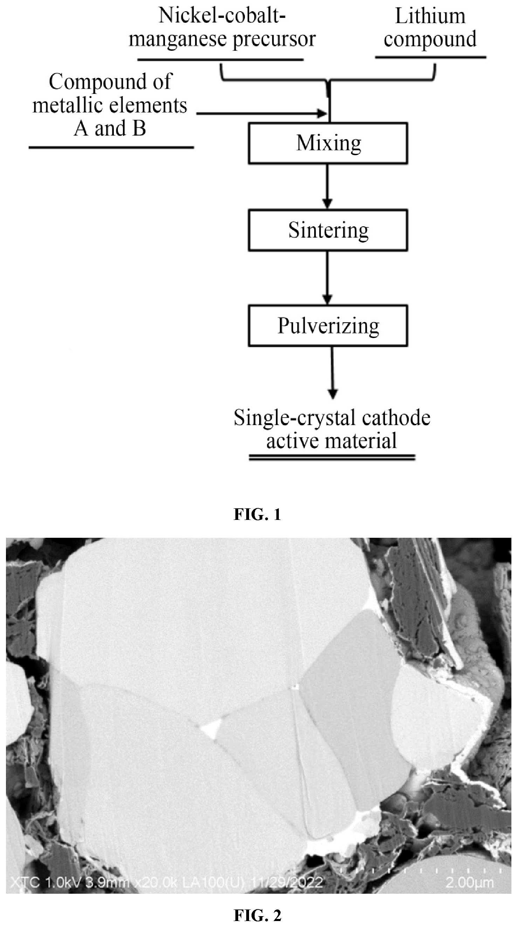

As shown in FIG. 1, the preparation method is specifically as follows:

### S1. Mixing and then sintering

A nickel-cobalt-manganese precursor, a lithium source, and additives are uniformly mixed to obtain a mixture, where the additives include an additive A and an additive B.

Optionally, a chemical formula of the nickel-cobalt-manganese precursor is NiₓCo_{y}Mn_{1-x-y}(OH)₂ or NiₓCo_{y}Mn_{1-x-y}CO₃, where, 0<x<1, 0<y<1, and 0<x+y<1.

Optionally, the lithium source is at least one selected from the group of lithium hydroxide and lithium carbonate.

Optionally, the lithium source involved in the sintering is added such that a molar ratio of a lithium element to the metal elements in the nickel-cobalt-manganese precursor is (1 to 1.07):1 (such as 1:1, 1.02:1, 1.04:1, 1.05:1, or 1.07:1).

Afterwards, the mixture is sintered in an oxygen-containing atmosphere, the sintering includes a low-temperature sintering stage, and the low-temperature sintering is carried out under the following conditions: a sintering atmosphere is an air atmosphere, an oxygen atmosphere, or a mixed atmosphere of oxygen and air, an oxygen volume fraction ranges from 20% to 100% (such as 20%, 40%, 60%, 80%, or 100%), a sintering temperature ranges from 400°C to 500°C (such as, 400°C, 430°C, 450°C, 480°C, or 500°C), and sintering ranges from 4 h to 6 h (such as 4 h, 5 h, or 6 h).

Further, the sintering further includes a high-temperature sintering stage, and the high-temperature sintering is carried out under the following conditions: on the basis of low-temperature sintering, the sintering temperature is increased to 830°C to 950°C (such as 830°C, 850°C, 880°C, 900°C, or 950°C), and sintering time ranges from 7.5 h to 12.5 h (such as 7.5 h, 8 h, 10 h, 12 h, or 12.5 h) to obtain a primary cathode material product.

During the high-temperature sintering stage, different sintering conditions are selected according to different metal element ratios, for example:
when 0<x≤0.4 and 0<x+y<1 in NixCoyMn1-x-y(OH)2, the high-temperature sintering is carried out under the following conditions: a sintering atmosphere is an oxygen atmosphere or an oxygen-containing mixed atmosphere, an oxygen volume fraction ranges from 20% to 100% (such as 20%, 40%, 60%, 80%, or 100%), a temperature ranges from 900°C to 950°C (such as 900°C, 910°C, 920°C, 930°C, or 950°C), and sintering time ranges from 7.5 h to 8.5 h (for example 7.5 h, 8 h, or 8.5 h);
when 0.4<x≤0.6 and 0.4<x+y<1 in NixCoyMn1-x-y(OH)2, the high-temperature sintering is carried out under the following conditions: a sintering atmosphere is an oxygen atmosphere or an oxygen-containing mixed atmosphere, an oxygen volume fraction ranges from 30% to 100% (such as 30%, 40%, 60%, 80%, or 100%), a temperature ranges from 880°C to 930°C (such as 880°C, 890°C, 900°C, 920°C, or 930°C), and sintering time ranges from 9.5 h to 10.5 h (for example 9.5 h, 10 h, or 10.5 h);
when 0.6<x≤0.7 and 0.6<x+y<1 in NixCoyMn1-x-y(OH)2, the high-temperature sintering is carried out under the following conditions: a sintering atmosphere is an oxygen atmosphere or an oxygen-containing mixed atmosphere, an oxygen volume fraction ranges from 60% to 100% (such as 60%, 70%, 80%, 90%, or 100%), a temperature ranges from 870°C to 920°C (such as 870°C, 880°C, 890°C, 900°C, or 920°C), and sintering time ranges from 9.5 h to 10.5 h (for example 9.5 h, 10 h, or 10.5 h);
when 0.7<x≤1 and 0.7<x+y<1 in NixCoyMn1-x-y(OH)2, the high-temperature sintering is carried out under the following conditions: a sintering atmosphere is an oxygen atmosphere or an oxygen-containing mixed atmosphere, an oxygen volume fraction ranges from 70% to 100% (such as 70%, 80%, 90%, or 100%), a temperature ranges from 830°C to 900°C (such as 830°C, 850°C, 870°C, 890°C, or 900°C), and sintering time ranges from 11.5 h to 12.5 h (for example 11.5 h, 12 h, or 12.5 h).

The setting of the low-temperature sintering stage prior to the high-temperature sintering stage can enable a sufficient reaction of the additives, which is conducive to formation of more modification layers at the internal grain boundary, thereby further improving electrochemical performance of the cathode material.

To obtain the cathode material with uniform particle size distribution and better electrochemical performance, the method further includes step S2 as follows:

### S2. Pulverizing

The primary cathode material product is subjected to jaw crushing, roll crushing, and air-jet pulverization, the cathode material is pulverized from D50 of 5 µm to 10 µm to D50 of 2 µm to 10 µm, thereby obtaining a single-crystal lithium nickel cobalt manganese cathode material with a modification layer at the internal grain boundary.

A cathode provided by an embodiment of the present disclosure is prepared from the cathode material provided by the embodiment of the present disclosure or the cathode material prepared by the preparation method provided by the embodiment of the present disclosure. The cathode includes the cathode material provided by the embodiment of the present disclosure, and thus has better electrochemical performance.

Specifically, the cathode includes a current collector and a coating material disposed on a surface of the current collector, where the coating material includes the cathode material provided by the embodiment of the present disclosure, a conductive material, and a binder. A preparation method for the cathode includes: dispersing the cathode material, the conductive material, and the binder into a solvent according to a specific proportion, uniformly mixing to obtain a dispersion solution, then coating the dispersion solution on the current collector, drying, and slicing to obtain the cathode.

A battery provided by an embodiment of the present disclosure includes the cathode provided by the embodiment of the present disclosure. The battery includes the cathode provided by the embodiment of the present disclosure, and thus has better electrochemical performance.

Specifically, the battery includes the cathode, an anode, as well as a separator and an electrolyte arranged between the cathode and the anode.

Characteristics and performance of the present disclosure are further described in detail below with reference to embodiments.

### Embodiment 1

Lithium hydroxide, a nickel-cobalt-manganese precursor with a chemical formula of Ni0.4Co0.3Mn0.3(OH)2, an additive A, and an additive B are mixed using a ball-milling mixer to obtain a mixture. A molar ratio of lithium in the lithium hydroxide to the metal elements in the Ni_{0.4}Co_{0.3}Mn_{0.3}(OH)₂ is 1.07:1. The additive A is WO₃, and an addition amount thereof (a ratio of the additive A to the prepared cathode material) is 6000 ppm. The additive B is Ba(OH)₂, and an addition amount thereof (a ratio of the additive B to the prepared cathode material) is 2000 ppm. Each of the additive A and the additive B has a BET of 8 m²/g.

The mixture is sintered in a high-temperature roller hearth sintering furnace, which is held at 450 °C for 5 h in an atmosphere with an oxygen concentration of approximately 20% (air atmosphere), followed by heating to 950 °C and holding for 8 h. Subsequently, a sintered compact is crushed using a jaw crusher and a roll crusher, followed by air-jet pulverization to obtain a single-crystal Li-Ni-Co-Mn cathode material with a modification layer at the internal grain boundary and a D50 of 5 µm.

### Embodiment 2

This embodiment is basically the same as Embodiment 1, except that:
a chemical formula of the nickel-cobalt-manganese precursor is changed as Ni_{0.6}Co_{0.2}Mn_{0.2}(OH)₂, a molar ratio of lithium in the lithium hydroxide to the metal elements in the Ni_{0.6}Co_{0.2}Mn_{0.2}(OH)₂ is 1.05:1, an oxygen concentration is 60%, the sintering is carried out at 500 °C for 4 h, then the temperature is increased to 930 °C and held for 10 h.

The additive A has a BET of 10 m²/g, and the additive B has a BET of 5 m²/g.

### Embodiment 3

This embodiment is basically the same as Embodiment 1, except that:
a chemical formula of the nickel-cobalt-manganese precursor is changed as Ni_{0.7}Co_{0.1}Mn_{0.2}(OH)₂, a molar ratio of lithium in the lithium hydroxide to the metal elements in the Ni_{0.7}Co_{0.1}Mn_{0.2}(OH)₂ is 1.03:1, an oxygen concentration is 80%, the sintering is carried out at 450 °C for 5 h, then the temperature is increased to 890 °C and held for 10 h.

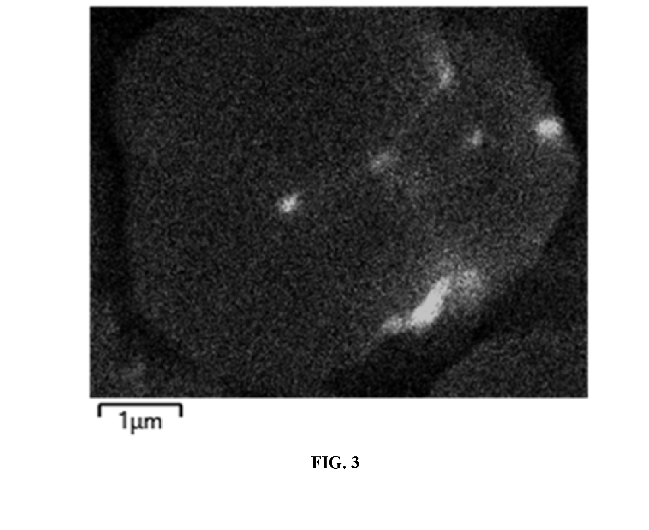

The prepared precursor is shown in FIG. 2 and FIG. 3.

### Embodiment 4

This embodiment is basically the same as Embodiment 1, except that:
a chemical formula of the nickel-cobalt-manganese precursor is changed as Ni_{0.8}Co_{0.1}Mn_{0.1}(OH)₂, a molar ratio of lithium in the lithium hydroxide to the metal elements in the Ni₀₈Co_{0.1}Mn_{0.1}(OH)₂ is 1.01:1, an oxygen concentration is 100%, the sintering is carried out at 400°C for 6 h, then the temperature is increased to 830 °C and held for 12 h.

The additive A has a BET of 5 m²/g, and the additive B has a BET of 5 m²/g.

### Embodiment 5

This embodiment is basically the same as Embodiment 3, except that the additive B is Ca(OH)₂.

### Embodiment 6

This embodiment is basically the same as Embodiment 3, except that the additive A is MoO₃, and the additive B is Ca(OH)₂.

### Embodiment 7

This embodiment is basically the same as Embodiment 3, except that the additive A is NH₄ReO₄.

### Embodiment 8

This embodiment is basically the same as Embodiment 3, except that an addition amount of the additive A is 1500 ppm, and an addition amount of the additive B is 500 ppm.

### Embodiment 9

This embodiment is basically the same as Embodiment 3, except that an addition amount of the additive A is 3000 ppm, and an addition amount of the additive B is 3000 ppm.

### Embodiment 10

This embodiment is basically the same as Embodiment 3, except that an addition amount of the additive A is 2000 ppm, and an addition amount of the additive B is 6000 ppm.

### Embodiment 11

This embodiment is basically the same as Embodiment 3, except that temperature of 890 °C is changed to 900°C.

### Embodiment 12

This embodiment is basically the same as Embodiment 3, except that temperature of 890 °C is changed to 880°C.

### Embodiment 13

This embodiment is basically the same as Embodiment 3, except that an oxygen concentration is 60%.

### Embodiment 14

This embodiment is basically the same as Embodiment 3, except that there is no low-temperature sintering stage, that is, sintering is carried out under conditions as follows: the sintering is completed by holding at 890°C for 10 h in an atmosphere with an oxygen concentration of 80%.

### Comparative Example 1

This comparative example is basically the same as Embodiment 3, except that an additive A and an additive B are not added.

### Comparative Example 2

This comparative example is basically the same as Embodiment 3, except that an additive A is not added.

### Comparative Example 3

This comparative example is basically the same as Embodiment 3, except that an additive B is not added.

### Comparative Example 4

This comparative example is basically the same as Embodiment 3, except that an addition amount of an additive A is 7000 ppm.

### Comparative Example 5

This comparative example is basically the same as Embodiment 10, except that an addition amount of an additive B is 7000 ppm.

### Comparative Example 6

This comparative example is basically the same as Embodiment 3, except that an additive A has a BET of 15 m²/g, and an additive B has a BET of 15 m²/g.

### Comparative Example 7

This comparative example is basically the same as Embodiment 4, except that an additive A has a BET of 3 m²/g, and an additive B has a BET of 3 m²/g.

### Comparative Example 8

This comparative example is basically the same as Embodiment 3, except that:
an additive A has a BET of 10 m²/g, and an additive B has a BET of 5 m²/g.

### Experimental example

The electrochemical performance of each coin cell fabricated from the cathode materials prepared in Embodiments 1 to 14 and Comparative Examples 1 to 8 is tested.

A fabrication method for each of coin cell is as follows. The foregoing cathode material, carbon black and a binder are mixed according to a specific mass ratio to obtain a mixture, then the mixture is placed in a degassing machine for mixing to obtain an electrode material, then the electrode material is coated on aluminum foil by means of blade coating, and afterwards, the aluminum foil is subjected to vacuum drying, followed by roll pressing to obtain a cathode sheet.

The binder, for example, may be polyvinylidene fluoride PVDF. A mass ratio of the cathode material the carbon black and the binder may be 94:3:3.

Each of the electrode sheet obtained in Embodiments 1 to 15 and Comparative Examples 1 to 8 is assembled to obtain the coin cell. A test environment temperature is 25°C, a charge-discharge test is conducted at a rate of 0.1C, a capacity retention is tested at 45°C and 1C rate, and the results are shown in Table 1.

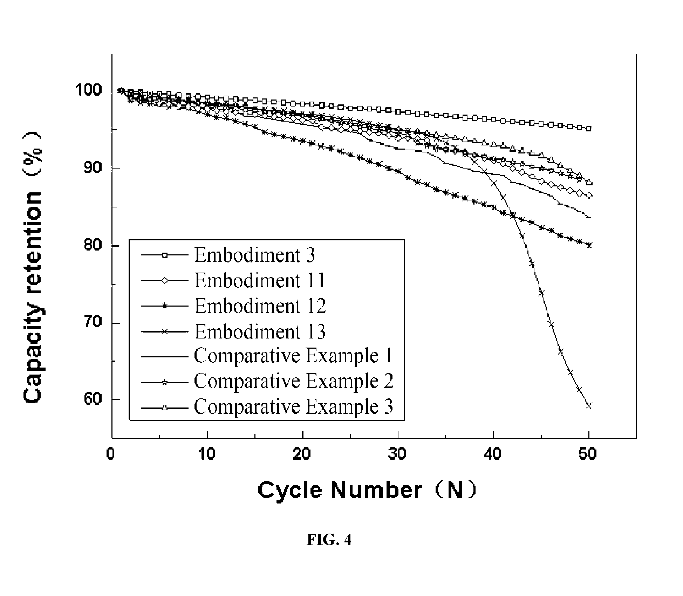

The test results are recorded in Table 1 and FIG. 4.

**Table 1 Electrochemical performance test of each embodiment and comparative example**

| | Test voltage | Initial discharge specific capacity (mAh/g) | DCR (Ω) |
|---|---|---|---|
| Embodiment 1 | 4.5 V | 186.5 | 8.2 |
| Embodiment 2 | 4.45 V | 203.4 | 9.1 |
| Embodiment 3 | 4.45 V | 212.6 | 9.7 |
| Embodiment 4 | 4.4 V | 220.1 | 9.2 |
| Embodiment 5 | 4.45 V | 210.8 | 11.7 |
| Embodiment 6 | 4.45 V | 211.1 | 10.8 |
| Embodiment 7 | 4.45 V | 211.1 | 12.2 |
| Embodiment 8 | 4.45 V | 210.5 | 10.6 |
| Embodiment 9 | 4.45 V | 210.3 | 10.3 |
| Embodiment 10 | 4.45 V | 209.2 | 12.1 |
| Embodiment 11 | 4.45 V | 208.1 | 12.6 |
| Embodiment 12 | 4.45 V | 207.7 | 16.2 |
| Embodiment 13 | 4.45 V | 208.2 | 17.3 |
| Embodiment 14 | 4.45 V | 211.3 | 13.7 |
| Comparative Example 1 | 4.45 V | 204.6 | 13.5 |
| Comparative Example 2 | 4.45 V | 207.3 | 11.2 |
| Comparative Example 3 | 4.45 V | 205.0 | 9.8 |
| Comparative Example 4 | 4.45 V | 202.67 | 14.9 |
| Comparative Example 5 | 4.45 V | 199.4 | 18.3 |
| Comparative Example 6 | 4.45 V | 198.6 | 19.7 |
| Comparative Example 7 | 4.4 V | 215.6 | 23.1 |
| Comparative Example 8 | 4.45 V | 204.6 | 20.9 |

As can be seen from Table 1 and FIG. 4, the cathode material prepared in each embodiment of the present disclosure has better electrochemical performance.

A comparison between Embodiment 3 and Comparative Examples 1 to 3 shows that Embodiment 3 exhibits significantly higher initial discharge specific capacity and remarkably lower impedance, indicating that simultaneous addition of the additives A and B can significantly improve the electrochemical performance of the cathode material.

A comparison between Embodiment 3 and Comparative Example 4 shows that Comparative Example 4 exhibits poor capacity and increased impedance, indicating that when an addition amount of the additive A exceeds a range required by the present disclosure, the additive A may enter the interior of the single crystal to destroy a crystal structure, leading to degraded electrochemical performance.

A comparison between Embodiment 10 and Comparative Example 5 shows that Comparative Example 5 exhibits poor capacity and increased impedance, indicating that when the addition amount of the additive B exceeds the range required by the present disclosure, the additive B may enter the interior of the single crystal to destroy the crystal structure, leading to degraded electrochemical performance.

A comparison between Embodiment 3 and Comparative Example 6 shows that Comparative Example 6 exhibits poor capacity and poor impedance, indicating that when the BET of the additive exceeds a range required by the present disclosure, insufficient reaction between the additive and the lithium may occur, resulting in failure to form an effective modification layer and thus leading to degraded electrochemical performance.

A comparison between Embodiment 4 and Comparative Example 7 shows that Comparative Example 7 exhibits lower capacity but significantly increased impedance, indicating that when the BET of the additive is less than the range required by the present disclosure, a reaction between the additive and metals except lithium may occur, resulting in failure to form an effective modification layer and thus leading to degraded electrochemical performance.

A comparison between Embodiment 3 and Comparative Example 8 shows that Comparative Example 8 exhibits poor impedance, indicating that when the BET of the additive A cannot exceed that of the additive B, if the BET of the additive A is greater, the additive A may react with lithium in advance, resulting in failure to form an effective modification layer.

Comparisons between Embodiment 3 and Embodiments 11 to 13 show that Embodiment 3 exhibits better electrochemical performance.While compared with Embodiment 3, the temperature and the oxygen content are not optimum sintering conditions for the corresponding precursor in Embodiments 13 to 15, indicating that for the precursor Ni_{0.7}Co_{0.1}Mn_{0.2}(OH)₂, the optimal sintering conditions are that the high-temperature is 890°C and the oxygen content is 80%. The sintering under these conditions can yield the cathode material with better performance.

A comparison between Embodiment 3 and Embodiment 14 shows that Embodiment 3 exhibits better electrochemical performance but lower impedance, indicating that the low-temperature sintering stage is beneficial for the reaction of the additive, enabling the generated modification layer to protect the internal grain boundary better.

FIG. 3 is a high-temperature cycle curve diagram of Embodiment 3 and Comparative Example 1. As can be learned from the figure that the cathode material obtained in Embodiment 3 has the best high-temperature cycle performance.

In conclusion, according to a lithium nickel cobalt manganese cathode material provided by an embodiment of the present disclosure, a modification layer at an inner grain boundary can suppress a side reaction between a new interface exposed by the rupture of the inner grain boundary during the preparation or high-voltage charge and discharge and an electrolyte, and the modification layer can play a role of a fast-ionic conductor while protecting the inner grain boundary, thereby improving the capacity, rate, cycle and storage performance at a higher voltage. Therefore, the lithium nickel cobalt manganese cathode material provided by the embodiment of the present disclosure has excellent electrochemical performance.

According to a preparation method for the lithium nickel cobalt manganese cathode material provided by the embodiment of the present disclosure, the additives A and B are added during preparation, the element B can first react with a lithium compound during a low-temperature sintering stage to form a Li-B-O compound, which then reacts with element A to form a Li-B-A-O compound modification layer, so that the Li-B-A-O compound modification layer is merely enriched at the internal grain boundary and does not penetrate into the crystal interior. This reaction proceeds spontaneously. During preparation, it is required that specific surface area of each of the additive A and the additive B ranges from 5 m²/g to 10 m²/g, and the specific surface area of the additive A is not greater than that of the additive B. If the specific surface area of the additive A and the additive B (collectively referred to as additives hereinafter) is less than 5 m²/g, it is unfavorable for the reaction of the elements A and B with lithium. If the specific surface area of the additive is greater than 10 m²/g, the additive may react with elements other than lithium. If the specific surface area of the additive A is greater than that of the additive B, the element A may react with the lithium compound in advance. Conditions beyond the foregoing three requirement ranges cannot achieve the formation of a Li-containing compound coating layer merely at the internal grain boundary. In addition, this solution also requires that the additive A is added such that a ratio of the element A to a generated target lithium nickel cobalt manganese cathode material is less than or equal to 6000 ppm, and the additive B is added such that a ratio of the element B to the generated target lithium nickel cobalt manganese cathode material is less than or equal to 6000 ppm. If the content of the additive is higher than a requirement range, a reaction product of the additive and the lithium compound may enter the interior of the crystal to destroy an internal structure of the crystal.

The foregoing are merely optional embodiments of the present disclosure and are not intended to limit the present disclosure. For those skilled in the art, various modifications and changes can be made to the present disclosure. Any modifications, equivalents, improvements, and the like made within the spirit and principles of the present disclosure are intended to be included within the scope of protection of the present disclosure.

### Industrial practicability

A lithium nickel cobalt manganese cathode material provided by this solution includes a single-crystal lithium nickel cobalt manganese and a modification layer located at an internal grain boundary of the single-crystal lithium nickel cobalt manganese, where the modification layer is generated by a reaction of Li, A, B, and oxygen, element A is at least one selected from the group of elements W, Mo, and Re, and element B is at least one selected from the group of Ba and Ca. A preparation method for the lithium nickel cobalt manganese cathode material includes: uniformly mixing a nickel-cobalt-manganese precursor, a lithium source, an additive A, and an additive B, followed by sintering. According to the preparation method provided by the present disclosure, the lithium nickel cobalt manganese cathode material provided by the present disclosure can be prepared, the preparation method is simple, and the prepared cathode material has better electrochemical performance.

## Claims

1. A lithium nickel cobalt manganese cathode material, comprising a single-crystal lithium nickel cobalt manganese and a modification layer located at an internal grain boundary of the single-crystal lithium nickel cobalt manganese, wherein the modification layer is generated by a reaction of Li, A, B, and oxygen, element A is at least one selected from the group of elements W, Mo, and Re, and element B is at least one selected from the group of Ba and Ca.

2. The lithium nickel cobalt manganese cathode material according to claim 1, wherein a ratio of the element A to the lithium nickel cobalt manganese cathode material is 1500 ppm to 6000 ppm, and a ratio of the element B to the lithium nickel cobalt manganese cathode material is 500 ppm to 6000 ppm.

3. The lithium nickel cobalt manganese cathode material according to claim 1 or 2, wherein a chemical formula of the single-crystal lithium nickel cobalt manganese is LiNiₓCo_{y}Mn_{1-x-y}O₂, satisfying that 0<x<1, 0<y<1, and 0<x+y<1.

4. A preparation method for a lithium nickel cobalt manganese cathode material, comprising:
uniformly mixing a nickel-cobalt-manganese precursor, a lithium source, an additive A, and an additive B, followed by sintering, wherein
the additive A is a single substance of element A or a compound of the element A, the element A is at least one selected from the group of elements W, Mo, and Re; and the additive B is a single substance of element B or a compound of the element B, and the element B is at least one selected from the group of Ba and Ca;
the additive A has a BET ranging from 5 m²/g to 10 m²/g, the additive B has a BET ranging from 5 m²/g to 10 m²/g, and the BET of the additive A is less than or equal to that of the additive B;
the additive A is added such that a ratio of the element A to a generated target lithium nickel cobalt manganese cathode material is less than or equal to 6000 ppm, and the additive B is added such that a ratio of the element B to the generated target lithium nickel cobalt manganese cathode material is less than or equal to 6000 ppm.

5. The preparation method according to claim 4, wherein the additive A is added such that the ratio of the element A to the generated target lithium nickel cobalt manganese cathode material ranges from 1500 ppm to 6000 ppm, and the additive B is added such that the ratio of the element A to the generated target lithium nickel cobalt manganese cathode material ranges from 500 ppm to 6000 ppm.

6. The preparation method according to claim 4 or 5, wherein the lithium source is at least one selected from the group of lithium hydroxide and lithium carbonate;
optionally, the lithium source involved in the sintering is added such that a molar ratio of a lithium element to the metal elements in the nickel-cobalt-manganese precursor is (1 to 1.07):1; and
optionally, a chemical formula of the nickel-cobalt-manganese precursor is NiₓCo_{y}Mn_{1-x-y}(OH)₂ or NiₓCo_{y}Mn_{1-x-y}CO₃, satisfying that 0<x<1, 0<y<1, and 0<x+y<1.

7. The preparation method according to any one of claims 4 to 6, wherein the sintering comprises a high-temperature sintering stage;
when 0<x≤0.4 and 0<x+y<1 in NiₓCo_{y}Mn_{1-x-y}(OH)₂, high-temperature sintering is carried out under the following conditions: a sintering atmosphere is an oxygen atmosphere or an oxygen-containing mixed atmosphere, an oxygen volume fraction ranges from 20% to 100%, a temperature ranges from 900°C to 950°C, and sintering time ranges from 7.5 h to 8.5 h;
when 0.4<x≤0.6 and 0.4<x+y<1 in NiₓCo_{y}Mn_{1-x-y}(OH)₂, high-temperature sintering is carried out under the following conditions: a sintering atmosphere is an oxygen atmosphere or an oxygen-containing mixed atmosphere, an oxygen volume fraction ranges from 30% to 100%, a temperature ranges from 880°C to 930°C, and sintering time ranges from 9.5 h to 10.5 h;
when 0.6<x≤0.7 and 0.6<x+y<1 in NiₓCo_{y}Mn_{1-x-y}(OH)₂, high-temperature sintering is carried out under the following conditions: a sintering atmosphere is an oxygen atmosphere or an oxygen-containing mixed atmosphere, an oxygen volume fraction ranges from 60% to 100%, a temperature ranges from 870°C to 920°C, and sintering time ranges from 9.5 h to 10.5 h; and
when 0.7<x<1 and 0.7<x+y<1 in NiₓCo_{y}Mn_{1-x-y}(OH)₂, high-temperature sintering is carried out under the following conditions: a sintering atmosphere is an oxygen atmosphere or an oxygen-containing mixed atmosphere, an oxygen volume fraction ranges from 70% to 100%, a temperature ranges from 830°C to 900°C, and sintering time ranges from 11.5 h to 12.5 h;
optionally, the sintering further comprises a low-temperature sintering stage, and the low-temperature sintering is carried out under the following conditions: adding a low-temperature sintering step before the high-temperature sintering stage, a sintering temperature of 400°C to 500°C, and sintering time of 4 h to 6 h.

8. The preparation method according to any one of claims 4 to 7, wherein a primary cathode material product is obtained after sintering, and after obtaining the primary cathode material product, the method further comprises:
pulverizing the primary cathode material product from D50 of 5 µm to 10 µm into D50 of 2 µm to 10 µm.

9. A cathode, wherein the cathode is prepared from the cathode material according to any one of claims 1 to 3 or the cathode material prepared by the preparation method according to any one of claims 4 to 8.

10. A battery, comprising the cathode according to claim 9.
